# EUROPEAN PATENT APPLICATION

(11) **EP 4 786 559 A1**
(43) Date of publication of application: **05.08.2026**
(21) Application number: 24871909.8
(22) Date of filing: 13.09.2024
(51) Int. Cl.: C09K 3/14, B24B 37/00, C09G 1/02, H01L 21/304

(54) **POLISHING COMPOSITION**

(30) Priority: 26.09.2023 JP 2023162426
(71) Applicant: Fujimi Incorporated, Kiyosu-shi, Aichi 452-8502 (JP)
(72) Inventor: Nakagai, Yuichiro, Kiyosu-shi, Aichi 452-8502 (JP)
(74) Representative: Grünecker Patent- und Rechtsanwälte PartG mbB
(86) International application number: PCT/JP2024/032851
(87) International publication number: WO 2025/070114

(57) **Abstract**

An object is to provide a polishing composition that can further improve the polishing removal rate of an object to be polished such as silicon carbide, and can maintain the properties of the polishing composition even after storage at a relatively high temperature.

A polishing composition containing an oxidizing agent, a zirconium(IV) salt as a metal salt, and an aqueous medium.

## Description

### TECHNICAL FIELD

The present invention relates to a polishing composition.

### BACKGROUND ART

Silicon carbide (SiC) semiconductors have a high dielectric breakdown electric field strength, a high saturation drift speed of electrons, and a high thermal conductivity as compared with silicon semiconductors, and by using them, research and development have been conducted to achieve a power device that can operate at higher temperatures and higher speeds than conventional silicon devices. Above all, the development of a highly efficient switching element that can be used in a power source for driving a motor of an electric motorcycle, an electric automobile, a hybrid car etc. is attracting attention. To achieve such a power device, a silicon carbide single crystal substrate having a smooth surface for epitaxially growing a high-quality silicon carbide semiconductor layer is required.

As a light source for recording information at a high density, a blue laser diode is attracting attention, and furthermore, the need for a white laser diode as a light source substitutable for a fluorescent lamp or a light bulb is increasing.

Such light emitting elements are produced by using a gallium nitride (GaN) semiconductor, and as a substrate for forming a high-quality gallium nitride semiconductor layer, a silicon carbide single crystal substrate is used.

The silicon carbide single crystal substrate used for the above applications is required to have high processing accuracy with respect to the flatness of a substrate, the smoothness of a substrate surface, and the like. However, since a silicon carbide single crystal has significantly high hardness, the processability for producing a substrate is poor.

Thus, in Patent Literature 1, the above problem is attempted to be solved by providing a polishing agent for chemically and mechanically polishing a silicon carbide (SiC) single crystal substrate, including an oxidizing agent as an permanganate ion, silica particles having an average secondary particle size of 0.2 µm or less, and a dispersing medium, wherein a content of the oxidizing agent is 0.25% by mass or more and 5% by mass or less, and a content of the silica particles is 0.01% by mass or more and less than 20% by mass.

In Patent Literature 2, the achievement of a high removal rate of amorphous carbon is attempted by providing a slurry for chemical mechanical polishing (CMP), including an aqueous liquid carrier, a transition metal oxy compound such as oxy-nitrate, and a peroxidizing agent.

### Citation List

### Patent Literatures

Patent Literature 1: International Publication No. WO 2013/035539
Patent Literature 2: PCT International Application Publication No. 2023-512216

### SUMMARY OF INVENTION

### Technical Problem

However, the polishing composition of Patent Literature 1 cannot sufficiently increase the polishing removal rate, and it has been found that the properties of the polishing composition change when the polishing composition is stored at a relatively high temperature. It has also been found in the polishing composition of Patent Literature 2 that the maintainability of the properties of the polishing composition is poor.

Therefore, an object of the present invention is to provide a polishing composition that can further improve the polishing removal rate of an object to be polished such as silicon carbide and can maintain the properties of the polishing composition even after storage at a relatively high temperature.

### Solution to Problem

The above problem is solved by providing a polishing composition containing an oxidizing agent, a zirconium(IV) salt as a metal salt, and an aqueous medium.

### Effect of Invention

The present invention can provide a polishing composition that can further improve the polishing removal rate of an object to be polished such as silicon carbide and can maintain the properties of the polishing composition even after storage at a relatively high temperature.

### DESCRIPTION OF EMBODIMENTS

Hereinafter, the present invention will be described in detail. As used herein, "X to Y" is used as a meaning including numerical values described before and after "to" (X and Y) as the lower limit value and the upper limit value, and means "X or more and Y or less". When a plurality of "X to Y" is described, for example, when there is a description of "X1 to Y1, or X2 to Y2", all of the disclosure using each numerical value as the upper limit, the disclosure using each numerical value as the lower limit, and combinations of each upper limit and each lower limit are disclosed (that is, they are legal grounds for correction). Specifically, all of correction with X1 or more, correction with Y2 or less, correction with X1 or less, correction with Y2 or more, correction with X1 to X2, correction with X1 to Y2, and the like, must be considered to be legal. When the feature or aspect of the present disclosure is described from the viewpoint of a Markush group, those skilled in the art will recognize that the present disclosure is described from the viewpoint of any individual component of the Markush group or a subgroup of the component. Unless otherwise indicated, measurements of operation, physical properties, and the like are performed under the conditions of room temperature (20 to 25 °C)/relative humidity of 40 to 50%RH. The concentration described herein may be a concentration at the point of use (POU) or may be a concentration before dilution to the concentration at POU. The dilution factor may be 2 to 10 times. In addition, all the embodiments and combinations of descriptions disclosed herein must be understood to be disclosed in the present application. That is, they must be understood to be grounds for correction. When the content or concentration of each component is described and two or more kinds of components are contained, the content or concentration may be of the total amount of them.

The present invention is a polishing composition containing an oxidizing agent, a zirconium(IV) salt as a metal salt, and an aqueous medium. This configuration enables a polishing composition that can further improve the polishing removal rate of an object to be polished such as silicon carbide and can maintain the properties of the polishing composition even after storage at a relatively high temperature, to be provided. Hereinafter, the configuration of the polishing composition of the present invention will be described in detail.

### [Metal Salt]

The metal salt disclosed herein is a compound composed of a metal cation and an anion. The polishing composition of the present invention contains a zirconium(IV) salt as the metal salt. Zirconium in the zirconium(IV) salt of the present invention is turned into a cation in the polishing composition. In addition, in the present invention, the cation is formed of a single zirconium atom. That is, the zirconium cation is a cation formed of zirconium alone. By applying a polishing composition containing the zirconium(IV) salt as the metal salt in addition to the oxidizing agent, the polishing removal rate of the object to be polished such as silicon carbide can be further improved, and the properties of the polishing composition can be maintained even after storage at a relatively high temperature.

In some embodiments, the zirconium(IV) salt may be an inorganic acid salt or an organic acid salt. Examples of the inorganic acid salt include salts of hydrohalogenic acids such as hydrochloric acid, hydrobromic acid, and hydrofluoric acid; and nitric acid, sulfuric acid, carbonic acid, silicic acid, boric acid, and phosphoric acid. In some embodiments, examples of the organic acid salt include salts of organic carboxylic acids such as formic acid, acetic acid, propionic acid, benzoic acid, glycine acid, butyric acid, citric acid, tartaric acid, and trifluoroacetic acid; organic sulfonic acids such as methanesulfonic acid, trifluoromethanesulfonic acid, benzenesulfonic acid, and toluenesulfonic acid; organic phosphonic acids such as methylphosphonic acid, benzenephosphonic acid, and toluenephosphonic acid; and organic phosphoric acids such as ethylphosphoric acid. Above all, salts of hydrochloric acid, nitric acid, sulfuric acid, and phosphoric acid are preferable, salts of hydrochloric acid, nitric acid, and sulfuric acid are more preferable, and salts of hydrochloric acid and nitric acid are still more preferable.

In some embodiments, a salt of the zirconium cation and at least one anion of a nitrate ion (NO₃⁻) or a chloride anion (Cl⁻) is used as the metal salt. The zirconium cation which is a cation formed of zirconium alone is different from the zirconyl ZrO ion used in Comparative Example. Specifically, in the structure of zirconium nitrate, the central metal is tetravalent Zr, as represented by Zr(NO₃)₄. Whereas, in the structure of zirconyl nitrate, as represented by OZr(NO₃)₂, two valences of the central metal Zr are oxidized with oxygen atoms and the remaining two valences form a salt with 2 mol of nitrate ions. By using the zirconium cation which is a cation formed of zirconium alone as the present invention, the properties of the polishing composition can be maintained even after storage at a relatively high temperature.

In some embodiments, the zirconium(IV) salt is at least one of zirconium nitrate or zirconium chloride.

In some embodiments, the concentration of the metal salt (in particular, the zirconium(IV) salt) in the polishing composition is preferably 0.1 mM or more, 0.5 mM or more, 1 mM or more, 5 mM or more, 7 mM or more, 10 mM or more, 15 mM or more, 20 mM or more, or 25 mM or more. In some embodiments, the concentration of the metal salt (in particular, the zirconium(IV) salt) contained in the polishing composition is 7 mM or more. In some embodiments, the concentration of the metal salt (in particular, the zirconium(IV) salt) in the polishing composition is preferably 1000 mM or less, 850 mM or less, 500 mM or less, 300 mM or less, 200 mM or less, 100 mM or less, 50 mM or less, or 40 mM or less.

As described above, the concentration of the metal salt (in particular, the zirconium(IV) salt) in the polishing composition is preferably 0.1 mM or more and 1000 mM or less, 0.5 mM or more and 850 mM or less, 1 mM or more and 500 mM or less, 5 mM or more and 300 mM or less, 7 mM or more and 300 mM or less, 10 mM or more and 200 mM or less, 15 mM or more and 100 mM or less, 20 mM or more and 50 mM or less, or 25 mM or more and 40 mM or less. Note that, 1 mM = 1 mmol/L. In particular, when the concentration of the metal salt (in particular, the zirconium(IV) salt) is 7 mM or more in the polishing composition, the properties of the polishing composition can be maintained even after storage at a relatively high temperature.

According to some embodiments, 80% by mass or more, 85% by mass or more, 90% by mass or more, 95% by mass or more, 98% by mass or more, 99% by mass or more, 99.5% by mass or more, or 99.9% by mass or more of the metal salt contained in the polishing composition is composed of the zirconium(IV) salt (the upper limit is 100% by mass). According to some embodiments, 90% by mass or more, 95% by mass or more, 98% by mass or more, 99% by mass or more, 99.5% by mass or more, or 99.9% by mass or more of the metal salt contained in the polishing composition is composed of at least one of zirconium nitrate or zirconium chloride (the upper limit is 100% by mass).

The metal salt to be contained in the polishing composition may be prepared by purchasing a commercial product or by synthesis.

### [Oxidizing Agent]

The polishing composition of the present invention contains an oxidizing agent. The oxidizing agent causes an oxidation reaction on a substrate (e.g., SiC) surface in the polishing process and reduces the hardness of the surface, which may make the surface fragile. By using the oxidizing agent, the polishing removal rate can be effectively improved.

The oxidizing agent is not particularly limited, as long as it is a substance having an oxidation reduction potential sufficient to exert the action of oxidizing the substrate surface. For example, the oxidizing agent may be a substance having a higher oxidation reduction potential than the oxidation reduction potential of the substrate material at a pH where polishing is conducted. Here, the above pH at which polishing is conducted is usually the same as the pH of the polishing composition. The oxidation reduction potential of the substrate material employed is a value obtained by dispersing powder of the material (e.g., SiC) in water to form a slurry, adjusting the slurry to have the same pH as the polishing composition, and then measuring the oxidation reduction potential (oxidation reduction potential to a standard hydrogen electrode at a liquid temperature of 25°C) of the slurry using a commercially available oxidation-reduction potentiometer. Among the metal salts that may be contained in the polishing composition, a substance having an oxidation reduction potential sufficient to exert the action of oxidizing the substrate surface is included in the category of the oxidizing agent as used herein.

In some embodiments, the polishing composition contains a complex metal oxide as the oxidizing agent. Examples of the above complex metal oxide include a nitric acid or the like such as iron nitrate, silver nitrate, and aluminum nitrate; a ferric acid or the like such as potassium ferrate; a permanganic acid or the like such as sodium permanganate and potassium permanganate; a chromic acid or the like such as potassium chromate and potassium dichromate; a vanadic acid or the like such as ammonium vanadate, sodium vanadate, and potassium vanadate; a ruthenic acid or the like such as perruthenic acid or a salt thereof; a molybdic acid or the like such as molybdic acid, ammonium molybdate which is a salt thereof, and disodium molybdate; a rhenic acid or the like such as perrhenic acid or a salt thereof; and a tungstic acid or the like such as tungstic acid and disodium tungstate which is a salt thereof. Above all, a ferric acid or the like, permanganic acid or the like, and a chromic acid or the like are more preferable, and a permanganic acid or the like are further preferable. In some embodiments, the polishing composition contains a permanganic acid or the like as the oxidizing agent. The complex metal oxide may be used alone or in an appropriate combination of two or more. As used herein, " or the like" can be replaced with "compound(s)".

In some embodiments, the polishing composition contains an oxidizing agent other than the above complex metal oxide. Specific examples of the oxidizing agent other than the complex metal oxide include peroxides such as hydrogen peroxide; a persulfuric acid or the like such as persulfuric acid such as peroxomonosulfuric acid and peroxodisulfuric acid; a chloric acid or the like such as chloric acid; a perchloric acid or the like such as perchloric acid; a bromic acid or the like such as bromic acid; an iodic acid or the like such as iodic acid; a periodic acid or the like; and a ruthenic acid or the like such as perruthenic acid or a salt thereof. These may be used alone or in an appropriate combination of two or more.

In some embodiments, the polishing composition substantially contains no oxidizing agent other than the above complex metal oxide (e.g., hydrogen peroxide). The term "substantially contains no" means that no oxidizing agent other than the complex metal oxide (e.g., hydrogen peroxide) is contained, or if any oxidizing agent other than the complex metal oxide is contained, its concentration is 100 ppm by mass or less in the polishing composition.

In some embodiments, the content of the oxidizing agent (in particular, a permanganic acid or the like such as potassium permanganate) in the polishing composition is preferably 0.01% by mass or more, 0.05% by mass or more, 0.1% by mass or more, 0.5% by mass or more, 1% by mass or more, 1.5% by mass or more, 2% by mass or more, 2.5% by mass or more, 3% by mass or more, or 3.5% by mass or more. In some embodiments, the content of the oxidizing agent (in particular, a permanganic acid or the like such as potassium permanganate) in the polishing composition is preferably 40% by mass or less, 35% by mass or less, 30% by mass or less, 25% by mass or less, 20% by mass or less, 15% by mass or less, 10% by mass or less, 7.5% by mass or less, or 5% by mass or less.

As described above, the content of the oxidizing agent (in particular, a permanganic acid or the like such as potassium permanganate) in the polishing composition is preferably 0.01% by mass or more and 40% by mass or less, 0.05% by mass or more and 35% by mass or less, 0.1% by mass or more and 30% by mass or less, 0.5% by mass or more and 25% by mass or less, 1% by mass or more and 20% by mass or less, 1.5% by mass or more and 15% by mass or less, 2% by mass or more and 10% by mass or less, 3% by mass or more and 7.5% by mass or less, or 3.5% by mass or more and 5% by mass or less.

According to some embodiments, 80% by mass or more, 85% by mass or more, 90% by mass or more, 95% by mass or more, 98% by mass or more, 99% by mass or more, 99.5% by mass or more, or 99.9% by mass or more (the upper limit is 100% by mass) of the oxidizing agent contained in the polishing composition is a permanganic acid or the like such as potassium permanganate. According to some embodiments, 80% by mass or more, 85% by mass or more, 90% by mass or more, 95% by mass or more, 98% by mass or more, 99% by mass or more, 99.5% by mass or more, or 99.9% by mass or more (the upper limit is 100% by mass) of the oxidizing agent contained in the polishing composition is potassium permanganate.

### [Abrasive]

According to some embodiments, the polishing composition contains abrasive. The abrasive has an action of mechanically polishing the object to be polished (e.g., SiC).

Specific examples of the abrasive used in the present invention include metal oxides such as silicon oxides (silica), aluminium oxides (alumina), silicon oxides (silica), cerium oxides (ceria), zirconium oxides, titanium oxides (titania), and manganese oxides; metal carbides such as silicon carbide and titanium carbide; metal nitrides such as silicon nitride and titanium nitride; and metal borides such as titanium boride and tungsten boride. The abrasive may be used alone or as a mixture of two or more. Among silicon oxides (silica), colloidal silica is preferable. Colloidal silica can be produced by the sol-gel method. For example, colloidal silica can be obtained by subjecting a hydrolyzable silicon compound (e.g., alkoxysilane or a derivative thereof) serving as a raw material to a hydrolysis and condensation reaction.

Among these abrasive, at least one selected from the group consisting of metal oxides and metal carbides is preferable, from the viewpoint of obtaining preferable polishing removal rate. According to some embodiments, at least one of silica or alumina is preferably contained as the abrasive, from the viewpoint of obtaining preferable polishing removal rate.

According to some embodiments, the average secondary particle size of the abrasive (in particular, a silicon oxide, colloidal silica) is preferably 10 nm or more, 15 nm or more, 20 nm or more, 25 nm or more, 30 nm or more, 35 nm or more, 40 nm or more, 45 nm or more, 50 nm or more, or 52 nm or more. As the average secondary particle size of the abrasive increases, the polishing removal rate of the object to be polished may be improved. In addition, the average secondary particle size of the abrasive (in particular, a silicon oxide, colloidal silica) is preferably 105 nm or less, 100 nm or less, 95 nm or less, 90 nm or less, 85 nm or less, 80 nm or less, 75 nm or less, 70 nm or less, 65 nm or less, or 60 nm or less. As the average secondary particle size of the abrasive decreases, a surface having low defects and small roughness can be easily obtained.

As described above, the average secondary particle size of the abrasive (in particular, a silicon oxide, colloidal silica) is preferably 10 nm or more and 105 nm or less, 15 nm or more and 100 nm or less, 20 nm or more and 95 nm or less, 25 nm or more and 90 nm or less, 30 nm or more and 85 nm or less, 35 nm or more and 80 nm or less, 40 nm or more and 75 nm or less, 45 nm or more and 70 nm or less, 50 nm or more and 65 nm or less, or 52 nm or more and 60 nm or less.

The average secondary particle size of the abrasive as used herein can be measured by a laser diffraction scattering method, unless otherwise indicated. Specifically, the measurement can be performed by using a laser diffraction/scattering particle size distribution measurement apparatus (trade name "LA-950") manufactured by Horiba, Ltd.

According to some embodiments, the content of the abrasive (in particular, a silicon oxide, colloidal silica) in the polishing composition is preferably 0.001% by mass or more, 0.003% by mass or more, 0.005% by mass or more, 0.007% by mass or more, 0.01% by mass or more, 0.03% by mass or more, 0.05% by mass or more, 0.07% by mass or more, or 0.09% by mass or more. As the content of the abrasive increases, the polishing removal rate may increase. According to some embodiments, the content of the abrasive (in particular, a silicon oxide, colloidal silica) in the polishing composition is preferably 30% by mass or less, 25% by mass or less, 20% by mass or less, 15% by mass or less, 10% by mass or less, 5% by mass or less, 3% by mass or less, 1% by mass or less, or 0.5% by mass or less. As the content of the abrasive decreases, a surface having few defects such as scratches can be easily obtained by polishing using the polishing composition.

As described above, the content of the abrasive (in particular, a silicon oxide, colloidal silica) in the polishing composition is preferably 0.001% by mass or more and 30% by mass or less, 0.003% by mass or more and 25% by mass or less, 0.005% by mass or more and 20% by mass or less, 0.007% by mass or more and 15% by mass or less, 0.01% by mass or more and 10% by mass or less, 0.03% by mass or more and 5% by mass or less, 0.05% by mass or more and 3% by mass or less, 0.07% by mass or more and 1% by mass or less, or 0.09% by mass or more and 0.5% by mass or less.

According to some embodiments, 90% by mass or more, 95% by mass or more, 98% by mass or more, 99% by mass or more, 99.5% by mass or more, or 99.9% by mass or more (the upper limit is 100% by mass) of the abrasive contained in the polishing composition is colloidal silica.

According to some embodiments, the surfaces of the abrasive (in particular, a silicon oxide, colloidal silica) contained in the polishing composition are not subjected to treatment such that a treatment agent such as an organic acid (e.g., sulfonic acid) is chemically bonded.

### [Aqueous Medium]

The polishing composition of the present invention contains an aqueous medium for dissolving and dispersing respective components. The aqueous medium is preferably water. From the viewpoint of preventing the action of other components from being inhibited, water containing impurities as little as possible is preferable, and specifically, pure water or ultrapure water obtained by removing impurity ions with an ion exchange resin, and then removing foreign substances through a filter, or distilled water is preferable.

According to some embodiments, 80% by mass or more, 85% by mass or more, 90% by mass or more, 95% by mass or more, 98% by mass or more, 99% by mass or more, 99.5% by mass or more, or 99.9% by mass or more of the aqueous medium contained in the polishing composition is composed of water (the upper limit is 100% by mass).

### [pH of Polishing Composition]

According to some embodiments, the lower limit of the pH of the polishing composition is preferably 0.5 or more, more than 0.5, 0.6 or more, more than 0.6, 0.7 or more, more than 0.7, 0.8 or more, more than 0.8, 0.9 or more, more than 0.9, 1.0 or more, more than 1.0, 1.1 or more, more than 1.1, 1.2 or more, more than 1.2, 1.3 or more, more than 1.3, 1.4 or more, more than 1.4, 1.5 or more, more than 1.5, 1.6 or more, more than 1.6, or 1.7 or more. According to some embodiments, the upper limit of the pH of the polishing composition is preferably less than 7.0, 6.5 or less, less than 6.5, 6.0 or less, less than 6.0, 5.5 or less, less than 5.5, 5.0 or less, less than 5.0, 4.5 or less, less than 4.5, 4.0 or less, less than 4.0, 3.5 or less, less than 3.5, 3.0 or less, less than 3.0, 2.5 or less, less than 2.5, 2.0 or less, less than 2.0, 1.9 or less, or 1.8 or less. According to some embodiments, the pH of the polishing composition is 4.5 or less.

As described above, the pH of the polishing composition is preferably 0.5 or more and less than 7.0, more than 0.5 and less than 6.5, more than 0.6 and less than 6.0, more than 0.7 and less than 5.5, more than 0.8 and less than 4.5, more than 0.9 and less than 4.0, more than 1.0 and less than 3.5, more than 1.1 and less than 3.0, more than 1.2 and less than 2.5, more than 1.3 and less than 2.0, 1.4 or more and 1.9 or less, 1.5 or more and 1.9 or less, or 1.6 or more and 1.8 or less. According to some embodiments, the pH of the polishing composition is 0.5 or more and less than 2.5. With such embodiments, the effect capable of maintaining the properties of the polishing composition even after storage at a relatively high temperature is more enhanced. The pH can be measured by using a pH meter (e.g., a glass electrode type hydrogen ion concentration indicator (model number F-23) manufactured by Horiba, Ltd.).

According to some embodiments, the pH of the polishing composition may be adjusted to the desired value by adjusting a content of the oxidizing agent, the zirconium(IV) salt as the metal salt, and, as necessary, the abrasive in the aqueous medium (in particular, water); may be adjusted to the desired value by separately adding a pH adjusting agent as mentioned below in the aqueous medium (in particular, water); or may be adjusted to the desired value by adjusting a content of the oxidizing agent, the zirconium(IV) salt as the metal salt, and as necessary, the abrasive, without separately adding a pH adjusting agent as mentioned below in the aqueous medium (in particular, water).

According to some embodiments, a polishing composition containing an oxidizing agent, a zirconium(IV) salt as a metal salt, and an aqueous medium, wherein 80% by mass or more of the oxidizing agent is a permanganic acid or the like such as a potassium permanganate, and 80% by mass or more of the metal salt (excluding those function as the oxidizing agent as described above) is the zirconium(IV) salt.

### [Further Component]

According to some embodiments, the polishing composition may contain a "further component" as necessary, or may substantially contain no "further component". The term "substantially contain no" refers that the component is not contained, or if the component is contained, the content of the component is 100 ppm by mass or less in the polishing composition.

According to some embodiments, examples of the further component include, but are not limited to, an acid or a salt thereof or a base or a salt thereof that adjusts the pH of the polishing composition (pH adjusting agent), a water-soluble polymer that acts on the surface of the object to be polished or the abrasive surface, a corrosion inhibitor that prevents the corrosion of the object to be polished, a chelating agent, and an antiseptic agent and mildew-proofing agent that have other functions.

Any one of an inorganic acid and an organic acid may be used as the acid. Examples of the inorganic acid include hydrochloric acid, sulfuric acid, nitric acid, hydrofluoric acid, boric acid, carbonic acid, hypophosphorous acid, phosphorus acid, and phosphoric acid. Examples of the organic acid include formic acid, acetic acid, propionic acid, butyric acid, valeric acid, 2-methylbutyric acid, n-hexanoic acid, 3,3-dimethylbutyric acid, 2-ethylbutyric acid, 4-methylpentanoic acid, n-heptanoic acid, 2-methylhexanoic acid, n-octanoic acid, 2-ethylhexanoic acid, benzoic acid, glycolic acid, salicylic acid, glyceric acid, oxalic acid, malonic acid, succinic acid, glutaric acid, adipic acid, pimelic acid, maleic acid, phthalic acid, malic acid, tartaric acid, citric acid, lactic acid, diglycolic acid, 2-furancarboxylic acid, 2,5-furandicarboxylic acid, 3-furancarboxylic acid, 2-tetrahydrofuran carboxylic acid, methoxyacetic acid, methoxyphenylacetic acid, phenoxyacetic acid, methanesulfonic acid, ethanesulfonic acid, sulfosuccinic acid, benzenesulfonic acid, toluenesulfonic acid, phenylphosphonic acid, and hydroxyethane-1,1-diphosphonic acid. Further, examples of the salt include a group 1 element salt, a group 2 element salt, an aluminum salt, an ammonium salt, an amine salt, and a quaternary ammonium salt. These acids or salts thereof may be used alone or in combination of two or more. Among these, nitric acid or hydrochloric acid is preferable.

The content of the acid or a salt thereof in the polishing composition can be appropriately adjusted so as to fall in the above pH range.

Examples of the base or a salt thereof include amines such as aliphatic amine and aromatic amine; organic bases such as quaternary ammonium hydroxide; hydroxides of alkali metals, such as sodium hydroxide and potassium hydroxide; hydroxides of group 2 elements, such as magnesium hydroxide and calcium hydroxide; and ammonia.

The content of the base or a salt thereof in the polishing composition is only required to be appropriately adjusted so as to fall in the above pH range.

Examples of the water-soluble polymer include polycarboxylic acids such as polyacrylic acid, polyphosphonic acid, polysulfonic acids such as polystyrenesulfonic acid, a polysaccharide or the like such as xanthan gum and sodium alginate, cellulose derivatives such as hydroxyethyl cellulose and carboxymethyl cellulose, polyethylene glycol, polyvinyl alcohol, polyvinylpyrrolidone, polyoxyethylene alkyl ether, polyoxyethylene alkyl phenyl ether, sorbitan monooleate, and oxyalkylene polymers having a single or a plurality of types of oxyalkylene units. In addition, at least one of poly(t-butylacrylamidesulfonic acid) (= polyATBS) or a poly(acrylic acid/t-butylacrylamidesulfonic acid) copolymer is suitable as an example of the water-soluble polymer. The salts of the above compounds can also be suitably used as the water-soluble polymer.

Examples of the corrosion inhibitor include an amine or the like, a pyridine or the like, tetraphenylphosphonium salts, a benzotriazole or the like, a triazole or the like, a tetrazole or the like, and benzoic acid. Examples of the chelating agent include carboxylic acid-based chelating agents such as gluconic acid; amine-based chelating agents such as ethylenediamine, diethylenetriamine, and trimethyltetraamine; polyamino polycarboxylic chelating agents such as ethylenediaminetetraacetic acid, nitrilotriacetic acid, hydroxyethylethylenediaminetriacetic acid, triethylenetetraminehexaacetic acid, and diethylenetriaminepentaacetic acid; organic phosphonic acid-based chelating agents such as 2-aminoethylphosphonic acid, 1-hydroxyethylidene-1,1-diphosphonic acid, aminotri(methylene phosphonic acid), ethylenediaminetetrakis(methylene phosphonic acid), diethylenetriaminepenta(methylene phosphonic acid), ethane-1,1-diphosphonic acid, ethane-1,1,2-triphosphonic acid, methanehydroxyphosphonic acid, and 1-phosphonobutane-2,3,4-tricarboxylic acid; phenol derivatives, and 1,3-diketone.

Examples of the antiseptic agent include sodium hypochlorite. Examples of the mildew-proofing agent include oxazolines such as oxazolidine-2,5-dione.

In some embodiments, the polishing composition contains no layered compound, or if a layered compound is contained, the content is less than 0.01% by mass.

### [Method for Producing Polishing Composition]

A method for producing the polishing composition of the present invention is not particularly limited, and for example, the polishing composition of the present invention can be obtained by stirring and mixing an oxidizing agent, a zirconium(IV) salt as a metal salt, and an aqueous medium, and as necessary, abrasive, and as necessary, a further component, in an aqueous medium. The above explanation may be applied to the explanation of the oxidizing agent, the metal salt, the aqueous medium, the abrasive, and the further component.

The temperature at which respective components are mixed is not particularly limited, and is preferably 10°C or more and 40°C or less. To increase the rate of dissolution, heating may be conducted. In addition, the mixing time is also not particularly limited.

### [Object to be Polished]

An object to be polished is polished by applying the polishing composition of the present invention to an object to be polished. The object to be polished of the present invention is not particularly limited, and for example, a substrate having a surface formed of a semiconductor material, that is, a semiconductor substrate. Examples of the constituent material of the semiconductor substrate include semiconductors including a group 14 element such as silicon or germanium; and compound semiconductors such as SiC, SiGe, ZnS, ZnSe, InP, AlN, GaAs, GaN, AlGaAs, InGaAs, GaP, ZnTe, and CdTd. Among these, a compound semiconductor is preferable, and SiC (silicon carbide) is more preferable. According to some embodiments, the polishing composition is used to polish a semiconductor substrate, and the semiconductor substrate is a compound semiconductor substrate.

The material contained in the object to be polished of some embodiments have, for example, a Vickers hardness of 500 Hv or more. The above Vickers hardness is preferably 700 Hv or more, and for example, 1000 Hv or more, or 1500 Hv or more. The Vickers hardness of the material contained in the object to be polished may be 1800 Hv or more, 2000 Hv or more, or 2200 Hv or more. The upper limit of the Vickers hardness of the material contained in the object to be polished is not particularly limited, and for example, about 7000 Hv or less, 5000 Hv or less, or 3000 Hv or less. As used herein, the Vickers hardness can be measured in accordance with JIS R 1610:2003. The international standard corresponding to the above JIS standard is ISO 14705:2000.

As described above, the Vickers hardness of the material contained in the object to be polished in some embodiments may be 700 Hv or more and 7000 Hv or less, 1000 Hv or more and 5000 Hv or less, and 1500 Hv or more and 3000 Hv or less. In some embodiments, the Vickers hardness of the material contained in the object to be polished may be 1800 Hv or more and 3000 Hv or less, or 2000 Hv or more and 3000 Hv or less.

Examples of the material having a Vickers hardness of 1500 Hv or more include silicon carbide, silicon nitride, titanium nitride, and gallium nitride. The object to be polished in the technique disclosed herein may have a single crystal surface of any of the above mechanically and chemically stable materials. Above all, the surface of the object to be polished is preferably formed of either silicon carbide or gallium nitride, and more preferably formed of silicon carbide. Silicon carbide is expected as a compound semiconductor substrate material that causes less power loss and is excellent in heat resistance and the like, and a practical advantage of improving productivity by the improvement of the polishing removal rate is particularly large. The technique disclosed herein may be particularly preferably applied to the polishing for the single crystal surface of silicon carbide.

### [Polishing Method, Method for Producing Semiconductor Substrate]

The polishing composition of the present invention is suitably used for polishing a semiconductor substrate. Thus, in some embodiments, a polishing method including a step of polishing a semiconductor substrate by using the above polishing composition is provided. In some embodiments, a method for producing a semiconductor substrate using such a polishing method is also provided. Polishing of the object to be polished using the polishing composition of the present invention can be performed by using the apparatus and conditions used for usual polishing. Examples of the common polisher include a single side polisher and a double side polisher. In the single side polisher, a single side of the object to be polished is polished as follows: an object to be polished (preferably an object to be polished in the form of a substrate) is held using a holder called template, and a platen attached with a polishing cloth is pressed against a single side of the object to be polished and rotated while supplying the polishing composition. In the double side polisher, both sides of the object to be polished are polished as follows: an object to be polished is held using a holder called carrier, platens attached with a polishing cloth are pressed against the opposing surfaces of the object to be polished and rotated in the relative direction to each other while supplying the polishing composition from upward. At this time, polishing is achieved by the physical action caused by the friction of a polishing pad and the polishing composition with the object to be polished, and the chemical action of the polishing composition on the object to be polished.

There are various polishing pads used in the polishing method using the polishing composition of the present invention, for example, polishing pads of different materials, such as polyurethane type, foamed polyurethane type, non-woven fabric type, and suede type ones; those having different physical properties such as hardness and thickness; those further containing abrasive; and those containing no abrasive, and these may be used without limitation.

When the object to be polished is polished by using the polishing composition of some embodiments, the polishing composition already used in polishing may be recycled and used in polishing again. Examples of the method for reusing the polishing composition include a method in which the polishing composition discharged from a polisher is recycled in a tank and used by circulating the polishing composition into the polisher again. Circulation use of the polishing composition is useful in that the reduction in the amount of the polishing composition discharged as a waste liquid can lead to the reduction in the environmental load, and the reduction in the amount of the polishing composition used can lead to the suppression of the production cost required to polish the object to be polished.

When the polishing composition of some embodiments are circulated and used, a part or all of the abrasive, oxidizing agent, zirconium(IV) salt as the metal salt, and further additive that are consumed and lost by polishing may be added during circulation use as the composition adjusting agent. In this case, one obtained by mixing a part or all of the oxidizing agent, the zirconium(IV) salt as the metal salt, and as necessary, the abrasive, and the further additive at an arbitrary mixing ratio may be used as the composition adjusting agent. By additionally adding the composition adjusting agent, the polishing composition is adjusted to a composition suitable for reuse, and polishing is suitably maintained. The concentration of the oxidizing agent, zirconium(IV) salt as the metal salt, and as necessary, abrasive, and further additive contained in the composition adjusting agent is arbitrary without particular limitation, and is preferably, appropriately adjusted depending on the size of the circulation tank and the polishing conditions.

The polishing composition of some embodiments may be one part or multi part such as two part. In addition, the polishing composition of some embodiments may be prepared by diluting the stock solution of the polishing composition to, for example, 1.5 times or more, 5 times or more, or 10 times or more (e.g., 1.5 times or more and 20 times or less) using a dilute solution such as water.

The embodiments of the present invention have been described in detail, but these are exemplary and illustrative purposes and not restrictive, and it is apparent that the scope of the present invention should be interpreted by the accompanying claims.

The present invention includes the following aspects and modes:
1. A polishing composition containing an oxidizing agent, a zirconium(IV) salt as a metal salt, and an aqueous medium;
2. The polishing composition according to the above 1., wherein the polishing composition contains at least one of a nitrate ion (NO₃⁻) or a chloride anion (Cl⁻) as an anion of the metal salt;
3. The polishing composition according to the above 1. or 2., wherein the polishing composition contains a permanganic acid or the like as the oxidizing agent;
4. The polishing composition according to any of the above 1. to 3., wherein the polishing composition further contains abrasive;
5. The polishing composition according to the above 4., wherein the polishing composition contains at least one of silica or alumina as the abrasive;
6. The polishing composition according to any of the above 1. to 5., wherein a concentration of the metal salt is 7 mM or more;
7. The polishing composition according to any of the above 1. to 6., wherein the polishing composition has a pH of 4.5 or less;
8. The polishing composition according to any of the above 1. to 7., wherein the polishing composition has a pH of 0.5 or more and less than 2.5;
9. The polishing composition according to any of the above 1. to 8., wherein the polishing composition is used for polishing a semiconductor substrate, and the semiconductor substrate is a compound semiconductor substrate;
10. A polishing method, including a step of polishing a semiconductor substrate by using the polishing composition according to any of the above 1. to 9; and
11. A method for producing a semiconductor substrate using the polishing method according to the above 10.

### Examples

The present invention will be described further in detail by way of the following Examples and Comparative Examples. However, the technical scope of the present invention is not limited to the following Examples only. In the following Examples, unless otherwise indicated, operations were performed under the conditions of room temperature (25°C)/relative humidity of 40 to 50%RH.

### <Preparation of Polishing Composition>

Potassium permanganate as the oxidizing agent, colloidal silica (average secondary particle size: 57 nm) as the abrasive, the metal salt shown in Table 1, and the pH adjusting agent shown in Table 1 were mixed in water as the aqueous medium at room temperature (25°C) so that the content shown in Table 1 was achieved, thereby preparing each polishing composition. The description "-" indicates that no corresponding component is added.

The average secondary particle size of the abrasive was measured by using a laser diffraction/scattering particle size distribution measurement apparatus LA-950 manufactured by Horiba, Ltd. In the pH measurement, a pH meter (a glass electrode type hydrogen ion concentration indicator (model number F-23) manufactured by Horiba, Ltd.) was used, and a three-point calibration was performed by using standard buffer solutions (a phthalate pH buffer solution, pH: 4.01 (25°C), a neutral phosphate pH buffer solution, pH: 6.86 (25°C), a carbonate pH buffer solution, pH: 10.01 (25°C)). Thereafter, a glass electrode was put in the polishing composition to be measured. The pH can be ensured by measuring a value after the measured values have stabilized.

Using each polishing composition, the object to be polished was polished under the following polishing conditions.

### <Polishing Conditions>

Polisher: RDP-500 (manufactured by FUJIKOSHI MACHINERY CORP.)
Polishing pad: IC-1000 (manufactured by NITTA DuPont Inc.)
Polishing load: 490 gf/cm²
Platen rotational speed: 130 rpm
Flow rate: 20 ml/min
Polishing time: 10 min.

After polishing, the platen rotational speed was set to 50 rpm, brushing was performed with water for 5 minutes while using a PVA brush, water was then flowed onto the object to be polished at the same rotational speed for 3 minutes using a diamond dresser, and thereafter, brushing was performed again with water for 5 minutes while using a PVA brush.

### <Object to be Polished>

SiC substrate: 4 inch N type, 4H-SiC, 4° off, Vickers hardness 2000 to 2400 Hv.

### <Polishing Removal Rate (Removal Rate: RR)>

The polishing removal rate was calculated from the masses of the object to be polished before and after polishing. The unit of the polishing removal rate is nm/h (hour).

### <Maintainability of Properties of Polishing Composition>

Each polishing composition was allowed to stand still in an environment at 43°C for 12 days, and the change in the properties of the polishing composition was evaluated under the following criteria.

Good: No change in properties
Fair: Some black foreign substances were generated
Poor: A large amount of black foreign substances was generated.

**[Table 1]**

| | Oxidizing agent (wt%) | Abrasive (wt%) | Metal salt | Valence of metal salt | Metal salt concentration (mM) | Type of pH adjusting agent other than metal salt | pH | RR (nm/h) | Maintainability of properties |
|---|---|---|---|---|---|---|---|---|---|
| Example 1 | 4 | 0.1 | Zr(NO₃)₄ | IV | 30 | - | 1.76 | 6005 | Good |
| Example 2 | 4 | 0.1 | ZrCl₄ | IV | 30 | - | 1.75 | 5821 | Good |
| Comparative Example 1 | 4 | 0.1 | Al(NO₃)₃ | III | 30 | - | 3.4 | 4847 | Good |
| Comparative Example 2 | 4 | 0.1 | Al(NO₃)₃ | III | 30 | HNO₃ | 1.8 | 4943 | Fair |
| Comparative Example 3 | 4 | 0.1 | ZrO(NO₃)₂ | II | 30 | - | 1.75 | 5714 | Poor |
| Comparative Example 4 | 4 | 0.1 | - | | - | HNO₃ | 1.67 | 4336 | Poor |

It is found that the polishing compositions of Examples can further improve the polishing removal rate of an object to be polished such as silicon carbide and can maintain the properties of the polishing composition even after storage at a relatively high temperature.

Comparing Example 1 with Example 2, it is found that, particularly when zirconium nitrate is used as the metal salt, the polishing removal rate of an object to be polished such as silicon carbide can be more significantly improved.

Comparative Examples 1 and 2 are examples using no zirconium as the metal. It is found that the polishing compositions of Comparative Examples 1 and 2 cannot improve the polishing removal rate of an object to be polished such as silicon carbide. In particular, in the polishing composition of Comparative Example 2 in which the pH was adjusted to almost the same pH as in Examples, the polishing composition did not successfully maintain its properties, and some black foreign substances were generated.

In Comparative Example 3, the zirconyl ZrO cation was used instead of the zirconium cation which is a cation formed of zirconium alone. While the polishing composition successfully improved the polishing removal rate of an object to be polished such as silicon carbide to a certain extent, the maintainability of the properties of the polishing composition was significantly poor.

In the polishing composition of Comparative Example 4, no metal salt is contained. The polishing composition did not successfully improve the polishing removal rate of an object to be polished such as silicon carbide, and the maintainability of the properties of the polishing composition was also significantly poor.

Although it is not shown in Table 1, an example in which zirconium nitrate in Example 1 was changed to zirconium sulfate was also evaluated. The effect of improving the polishing removal rate thereof was mild as compared with the effects of Examples 1 and 2. The maintainability of the properties of the polishing composition was as good as zirconium nitrate.

The present application claims priority based on Japanese Patent Application No. 2023-162426 filed on September 26, 2023, which is incorporated herein by reference in its entirety.

## Claims

1. A polishing composition comprising:
an oxidizing agent;
a zirconium(IV) salt as a metal salt; and
an aqueous medium.

2. The polishing composition according to claim 1, wherein the polishing composition comprises at least one of a nitrate ion (NO₃⁻) or a chloride anion (Cl⁻) as an anion of the metal salt.

3. The polishing composition according to claim 1, wherein the polishing composition comprises a permanganic acid or the like as the oxidizing agent.

4. The polishing composition according to claim 1, wherein the polishing composition further comprises abrasive.

5. The polishing composition according to claim 4, wherein the polishing composition comprises at least one of silica or alumina as the abrasive.

6. The polishing composition according to claim 1, wherein a concentration of the metal salt is 7 mM or more.

7. The polishing composition according to claim 1, wherein the polishing composition has a pH of 4.5 or less.

8. The polishing composition according to claim 1, wherein the polishing composition has a pH of 0.5 or more and less than 2.5.

9. The polishing composition according to claim 1, wherein the polishing composition is used for polishing a semiconductor substrate, and the semiconductor substrate is a compound semiconductor substrate.

10. A polishing method, comprising a step of polishing a semiconductor substrate by using the polishing composition according to claim 1.

11. A method for producing a semiconductor substrate using the polishing method according to claim 10.
